# EUROPEAN PATENT APPLICATION

(11) **EP 4 827 301 A2**
(43) Date of publication of application: **21.10.2026**
(21) Application number: 26173460.2
(22) Date of filing: 20.04.2026
(51) Int. Cl.: H10N 10/10, F01D 21/00, F01D 25/36, F02C 3/14, F02C 7/32

(54) **AIRCRAFT POWERPLANT WITH THERMOELECTRIC GENERATOR**

(30) Priority: 18.04.2025 US 202519183414
(71) Applicant: RTX Corporation, Farmington, CT 06032 (US)
(72) Inventor: CLARK, Thomas E., Wells, 04090 (US); YAZICI, Murat, Glastonbury, 06033 (US)
(74) Representative: Dehns

(57) **Abstract**

An assembly is provided for an aircraft powerplant (20). This assembly includes an engine case, a combustor (118) and a thermoelectric generator (150). The engine case extends axially along and circumferentially around an axis (34). The engine case forms an outer peripheral boundary of a diffuser plenum (122). The combustor (118) is disposed in the diffuser plenum (122). The combustor (118) includes a combustor wall (130) and a combustion chamber (116) within the combustor (118). The combustor wall (130) borders the diffuser plenum (122) and forms an outer peripheral boundary of the combustion chamber (116). The thermoelectric generator (150) is arranged in the diffuser plenum (122). The thermoelectric generator (150) is located radially between and is spaced radially from the combustor wall (130) and the engine case. The thermoelectric generator (150) is configured to convert heat energy radiated out from the combustor (118) into electricity.

## Description

### BACKGROUND OF THE DISCLOSURE

### 1. Technical Field

This disclosure relates generally to an aircraft powerplant and, more particularly, to an electrical system for the aircraft powerplant.

### 2. Background Information

An aircraft powerplant such as an aircraft propulsion system may include one or more electrical systems. Various types of electrical systems are known in the art for aircraft powerplants. While these known electrical systems have various be nefits, there is still room in the art for improvement.

### SUMMARY OF THE DISCLOSURE

According to an aspect of the present disclosure, an assembly is provided for an aircraft powerplant. This assembly includes an engine case, a combustor and a thermoelectric generator. The engine case extends axially along and circumferentially around an axis. The engine case forms an outer peripheral boundary of a diffuser plenum. The combustor is disposed in the diffuser plenum. The combustor includes a combustor wall and a combustion chamber within the combustor. The combustor wall borders the diffuser plenum and forms an outer peripheral boundary of the combustion chamber. The thermoelectric generator is arranged in the diffuser plenum. The thermoelectric generator is located radially between and is spaced radially from the combustor wall and the engine case. The thermoelectric generator is configured to convert heat energy radiated out from the combustor into electricity.

According to another aspect of the present disclosure, another assembly is provided for an aircraft powerplant. This assembly includes a turbine engine and an electrical system. The turbine engine includes a combustor disposed in a diffuser plenum. The electrical system includes a thermoelectric generator, an electric device and an electrical power system. The thermoelectric generator is arranged in the diffuser plenum. The thermoelectric generator is configured to convert heat energy radiated out from the combustor into electricity. The electrical power system is electrically coupled to and between the thermoelectric generator and the electric device. The electrical power system is configured to electrically power the electric device for a period of time following shutdown of the turbine engine. The electric device is configured to facilitate a cool down operation for the turbine engine.

According to still another aspect of the present disclosure, another assembly is provided for an aircraft powerplant. This assembly includes a combustor and a thermoelectric generator. The combustor includes an inner combustor wall, an outer combustor wall, a bulkhead and a combustion chamber. The inner combustor wall extends axially along and circumferentially about an axis. The outer combustor wall extends axially along and circumferentially about the inner combustor wall. The bulkhead extends radially between the inner combustor wall and the outer combustor wall. The combustion chamber projects axially into the combustor to the bulkhead. The combustion chamber extends radially between the inner combustor wall and the outer combustor wall. The thermoelectric generator is radially outboard of and axially overlaps the combustor. An air channel is formed by and extends radially between the outer combustor wall and the thermoelectric generator.

The following optional features may be applied to any of the above aspects.

The electric device may be configured to one of: ventilate an internal compartment of the turbine engine to facilitate the cool down operation for the turbine engine; or rotate a rotating structure of the turbine engine to facilitate the cool down operation for the turbine engine. The rotating structure may include a bladed rotor in a compressor section of the turbine engine or a turbine section of the turbine engine.

The thermoelectric generator may be configured as or otherwise include a thermoelectric generator panel extending axially along and circumferentially about the combustor wall.

The thermoelectric generator may be arranged in the diffuser plenum to separate a region of the diffuser plenum into an inner flow channel and an outer flow channel. The inner flow channel may be disposed radially between and may be formed by the combustor wall and the thermoelectric generator. The outer flow channel may be disposed radially between and may be formed by the thermoelectric generator and the engine case.

The inner flow channel may be fluidly coupled to one or more apertures in the combustor wall.

The assembly may also include an engine component and an air circuit. The air circuit may be fluidly coupled to the outer flow channel and may be configured to deliver air received from the outer flow channel to the engine component.

The thermoelectric generator may axially overlap at least fifty percent of an axial length of the combustor.

The assembly may also include an electric device and an electrical power system electrically coupled to and between the thermoelectric generator and the electric device.

The electric device may be configured as or otherwise include an electronic engine controller.

The electric device may be configured as or otherwise include an electric motor.

The assembly may also include a compressor section, a combustor section, a turbine section, a flowpath and a rotating structure. The combustor section may include the combustor. The flowpath may extend through the compressor section, the combustor section and the turbine section from an airflow inlet into the flowpath to a combustion products exhaust from the flowpath. The rotating structure may include a bladed rotor disposed in the compressor section or the turbine section. The electric motor may be operatively coupled to and may be configured to drive rotation of the rotating structure.

The electric device may include an electric air mover.

The electrical power system may include a power storage.

The electrical power system may include an electrical distribution bus.

The electrical power system may include power electronics.

The assembly may also include a turbine engine comprising the engine case, the diffuser plenum and the combustor. The electrical power system may be configured to electrically power the electric device at least when the turbine engine is non-operational subsequent to the turbine engine being shutdown.

The electrical power system may be configured to electrically power the electric device by directing at least some of the electricity generated by the thermoelectric generator to the electric device.

The electrical power system may include a power storage. The electrical power system may be configured to store at least some of the electricity generated by the thermoelectric generator in the power storage. The electrical power system may be configured to electrically power the electric device by directing at least some of the electricity stored in the power storage to the electric device.

The present disclosure may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a partial schematic illustration of an aircraft propulsion system.
FIG. 2 is a schematic illustration of a portion of the aircraft propulsion system at a combustor section between a compressor section and a turbine section.
FIG. 3 is a partial sectional illustration of a member of a combustor.
FIG. 4 is a schematic illustration of a portion of the aircraft propulsion system at an electrical system.
FIG. 5 is an illustration of a portion of aircraft propulsion system at a thermoelectric generator within a combustor section.

### DETAILED DESCRIPTION

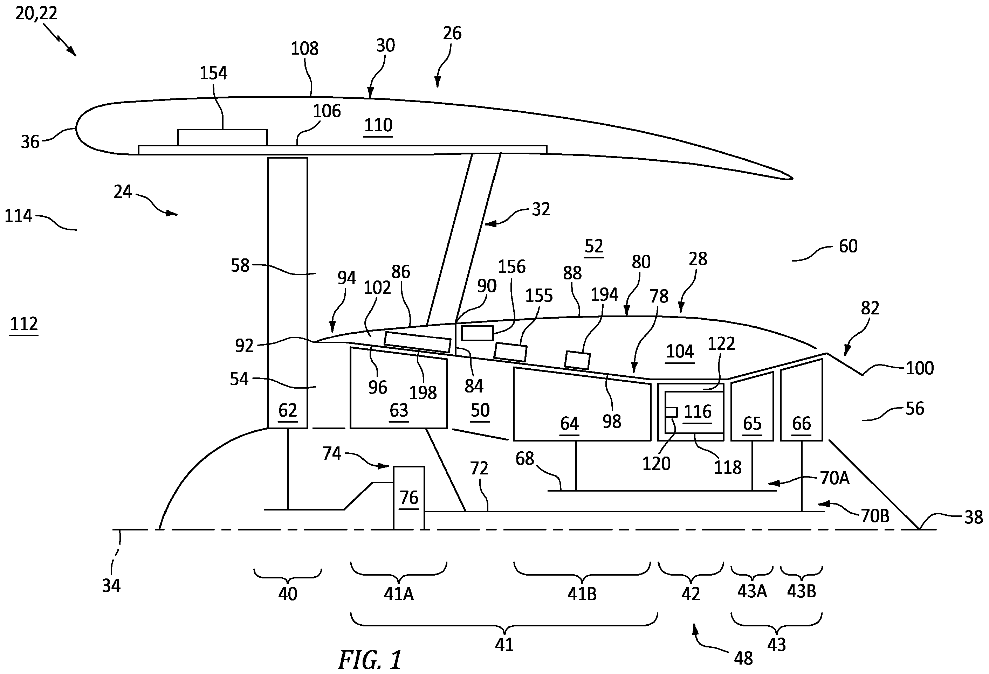

FIG. 1 illustrates a powerplant 20 for an aircraft. The aircraft may be an airplane, a rotorcraft (e.g., a helicopter), a drone (e.g., an unmanned aerial vehicle (UAV)) or any other manned or unmanned aerial vehicle or system. For ease of description, the aircraft powerplant 20 is described below as a propulsion system 22 for the aircraft and, more particularly, as a turbofan propulsion system. The aircraft powerplant 20 of the present disclosure, however, is not limited to such an exemplary propulsion system. The aircraft propulsion system 22, for example, may alternatively be configured as a turbojet propulsion system, a turboprop propulsion system, a turboshaft propulsion system, a propfan propulsion system, a pusher fan propulsion system, or any other type of ducted and/or open propulsor rotor propulsion system. Moreover, the aircraft powerplant 20 is not limited to propulsion system applications. The aircraft powerplant 20, for example, may also (or alternatively) be configured as an electrical power system for the aircraft; e.g., an auxiliary power unit (APU).

The aircraft propulsion system 22 includes a gas turbine engine 24 (e.g., a turbofan engine) housed within a stationary propulsion system housing 26, which propulsion system housing 26 of FIG. 1 includes an inner housing structure 28, an outer housing structure 30 and a guide vane structure 32 (e.g., a fan exit guide vane (FEGV) structure) extending radially between and connected to the inner housing structure 28 and the outer housing structure 30. The aircraft propulsion system 22 extends axially along an axis 34 of the aircraft propulsion system 22 between an axial upstream, forward end 36 of the aircraft propulsion system 22 and an axial downstream, aft end 38 of the aircraft propulsion system 22. Briefly, the propulsion system axis 34 may be a centerline axis of the aircraft propulsion system 22, the turbine engine 24 and/or one or more of its members. The propulsion system axis 34 may also or alternatively be a rotational axis for one or more members of the turbine engine 24.

The aircraft propulsion system 22 and its turbine engine 24 of FIG. 1 include a propulsor section 40 (e.g., a fan section), a compressor section 41, a combustor section 42 and a turbine section 43. The compressor section 41 of FIG. 1 includes a low pressure compressor (LPC) section 41A and a high pressure compressor (HPC) section 41B. The turbine section 43 of FIG. 1 includes a high pressure turbine (HPT) section 43A and a low pressure turbine (LPT) section 43B. At least (or only) the LPC section 41A, the HPC section 41B, the combustor section 42, the HPT section 43A and the LPT section 43B collectively form a core 48 (e.g., a gas generator) of the turbine engine 24. The aircraft propulsion system 22 and its turbine engine 24 of FIG. 1 also include a core flowpath 50 (e.g., an annular core flowpath) and a bypass flowpath 52 (e.g., an annular bypass flowpath). The core flowpath 50 extends sequentially through the LPC section 41A, the HPC section 41B, the combustor section 42, the HPT section 43A and the LPT section 43B from an airflow inlet 54 into the core flowpath 50 to a combustion products exhaust 56 out from the core flowpath 50. The bypass flowpath 52 extends through a bypass duct from an airflow inlet 58 into the bypass flowpath 52 to an airflow exhaust 60 from the bypass flowpath 52, where the bypass duct may be formed by the inner housing structure 28 and the outer housing structure 30. The bypass flowpath 52 and its bypass duct are configured to bypass (e.g., are disposed radially outboard of and extend along) the engine core 48 and the inner housing structure 28.

The propulsor section 40, the LPC section 41A, the HPC section 41B, the combustor section 42, the HPT section 43A and the LPT section 43B may be arranged sequentially along the propulsion system axis 34 within the propulsion system housing 26. The propulsor section 40 includes a bladed propulsor rotor 62; e.g., a fan rotor. The LPC section 41A includes a bladed low pressure compressor (LPC) rotor 63. The HPC section 41B includes a bladed high pressure compressor (HPC) rotor 64. The HPT section 43A includes a bladed high pressure turbine (HPT) rotor 65. The LPT section 43B includes a bladed low pressure turbine (LPT) rotor 66. Each of these engine rotors 62-66 includes a rotor base (e.g., a disk or a hub) and a plurality of rotor blades (e.g., airfoils, vanes, etc.). The rotor blades may be arranged into one or more stages axially along the respective engine rotor 62-66. The rotor blades in each stage are arranged and may be equispaced circumferentially around the respective rotor base in an annular array. Each of the rotor blades is connected to the respective rotor base. The rotor blades, for example, may be formed integral with or mechanically fastened, welded, brazed and/or otherwise attached to the respective rotor base. Each of the rotor blades projects spanwise (e.g., radially) out from the respective rotor base to a distal tip of the respective rotor blade.

The HPC rotor 64 is coupled to and rotatable with the HPT rotor 65. The HPC rotor 64 of FIG. 1, for example, is connected to the HPT rotor 65 through a high speed shaft 68. At least (or only) the HPC rotor 64, the HPT rotor 65 and the high speed shaft 68 collectively form a high speed rotating structure 70A; e.g., a high speed spool of the turbine engine 24 and its engine core 48. This high speed rotating structure 70A of FIG. 1 and its members 64, 65 and 68 are rotatable about the propulsion system axis 34. However, it is contemplated the high speed rotating structure 70A may alternatively be rotatable about another axis radially and/or angularly offset from the rotational axis of the propulsor rotor 62 and/or the centerline axis of the turbine engine 24.

The LPC rotor 63 is coupled to and rotatable with the LPT rotor 66. The LPC rotor 63 of FIG. 1, for example, is connected to the LPT rotor 66 through a low speed shaft 72. At least (or only) the LPC rotor 63, the LPT rotor 66 and the low speed shaft 72 collectively form a low speed rotating structure 70B; e.g., a low speed spool of the turbine engine 24 and its engine core 48. This low speed rotating structure 70B of FIG. 1 and its members 63, 66 and 72 are rotatable about the propulsion system axis 34. However, it is contemplated the low speed rotating structure 70B may alternatively be rotatable about another axis radially and/or angularly offset from the rotational axis of the propulsor rotor 62 and/or the centerline axis of the turbine engine 24.

The low speed rotating structure 70B is coupled to the propulsor rotor 62 through a rotating structure-to-propulsor (RSP) drivetrain 74. The RSP drivetrain 74 may be configured as a geared drivetrain, where a geartrain 76 (e.g., a transmission, a speed change device, an epicyclic geartrain, etc.) is disposed between and operatively couples the propulsor rotor 62 to the low speed rotating structure 70B and its LPT rotor 66. With this arrangement, the propulsor rotor 62 may rotate at a different (e.g., slower) rotational speed than the low speed rotating structure 70B and its LPT rotor 66. Here, the propulsor rotor 62 and the low speed rotating structure 70B may rotate in a common (the same) direction about the propulsion system axis 34 or in opposite directions about the propulsion system axis 34 depending, for example, upon the specific configuration of the geartrain 76. Alternatively, the RSP drivetrain 74 may be configured as a direct-drive drivetrain, where the geartrain 76 is omitted. With such an arrangement, the propulsor rotor 62 rotates at a common (the same) rotational speed as the low speed rotating structure 70B and its LPT rotor 66.

The inner housing structure 28 of FIG. 1 includes an inner case 78 (e.g., a core case), an inner wall structure 80, a core exhaust nozzle structure 82 and a bulkhead 84 (e.g., a firewall). The inner case 78 is disposed radially outboard of, extends axially along and may circumscribe one or more or all of the engine sections 41A-43B and the engine rotors 63-66. The inner case 78 may thereby house and provide a support structure for the respective engine sections 41A-43B and the engine rotors 63-66.

The inner wall structure 80 is configured to provide an aerodynamic cover over the engine core 48 and its inner case 78. This inner wall structure 80 is also configured to form a radial inner peripheral boundary of the bypass flowpath 52. The inner wall structure 80 of FIG. 1, for example, includes an inner flowpath wall 86 (e.g., an outer casing of the inner housing structure 28) and an inner nacelle structure 88 (e.g., an inner fixed structure (IFS)). The inner flowpath wall 86 may form a radial inner platform for the guide vane structure 32. The inner flowpath wall 86 of FIG. 1, for example, projects axially (in an upstream, forward direction) from an axial downstream, aft end 90 of the guide vane structure 32 to or near a leading edge 92 of a splitter structure 94. Here, the inner flowpath wall 86 extends axially along and may circumscribe at least a section 96 of the inner case 78 housing the LPC section 41A and its LPC rotor 63. The leading edge 92 of the splitter structure 94 forms a radial outer peripheral boundary of the core inlet 54 and a radial inner peripheral boundary of the bypass inlet 58. The inner nacelle structure 88 extends axially (in a downstream, aft direction) from the inner flowpath wall 86 to or near the core exhaust nozzle structure 82. Here, the inner nacelle structure 88 extends axially along and circumferentially about at least a section 98 of the inner case 78 housing the engine sections 41A-43B and the engine rotors 63-66. A trailing edge 100 of the core exhaust nozzle structure 82 forms a radial outer peripheral boundary of the core exhaust 56.

The bulkhead 84 projects radially out from the inner case 78 to the inner flowpath wall 86. The bulkhead 84 is also mechanically fastened and/or otherwise attached to the inner case 78 and the inner flowpath wall 86. The bulkhead 84 of FIG. 1, in particular, is attached to the inner flowpath wall 86 at (or about) the aft end 90 of the guide vane structure 32. The bulkhead 84 extends circumferentially about (e.g., completely around) the inner case 78 and the propulsion system axis 34. This bulkhead 84 may be configured as a firewall or other barrier spatially and/or fluidly dividing a forward inner housing compartment 102 of the inner housing structure 28 from an aft inner housing compartment 104 (e.g., an engine core compartment) of the inner housing structure 28. The forward inner housing compartment 102 may be formed by and extend radially between the inner case 78 and the inner flowpath wall 86. This forward inner housing compartment 102 extends axially along the inner case 78 and the inner flowpath wall 86 (in the downstream, aft direction) to the bulkhead 84, thereby axially overlapping the LPC section 41A. The aft inner housing compartment 104 may be formed by and extend radially between the inner case 78 and the inner nacelle structure 88. This aft inner housing compartment 104 may also extend axially along the inner case 78 and the inner nacelle structure 88 (in the upstream, forward direction) to the bulkhead 84, thereby axially overlapping one or more of the engine sections 41B-43B.

The outer housing structure 30 of FIG. 1 includes an outer case 106 (e.g., a fan case) for the turbine engine 24, an outer nacelle structure 108 and an internal outer housing compartment 110. The outer case 106 is disposed radially outboard of, extends axially along and may circumscribe the propulsor section 40 and its propulsor rotor 62. The outer case 106 may thereby house and may be configured as a containment structure for the propulsor section 40 and its propulsor rotor 62. The outer nacelle structure 108 is configured to provide an aerodynamic cover over the outer case 106. The outer housing compartment 110 of FIG. 1 is at least partially formed by and disposed radially between the outer case 106 and an outer portion (e.g., fan cowls) of the outer nacelle structure 108. The outer housing structure 30 and its outer nacelle structure 108 may also form a radial outer peripheral boundary of the bypass flowpath 52.

During turbine engine operation, ambient air from an environment 112 external to the aircraft and its aircraft propulsion system 22 enters the aircraft propulsion system 22 and its turbine engine 24 through an airflow inlet 114. This air is directed across the propulsor section 40 and is propelled by the propulsor rotor 62. The air propelled by the propulsor rotor 62 is subsequently split into a radial inner stream of air and a radial outer stream of air by the splitter structure 94. The inner air stream is directed into the core flowpath 50. This air entering the core flowpath 50 may be referred to as "core air". The outer air stream is directed into the bypass flowpath 52. The air entering the bypass flowpath 52 may be referred to as "bypass air".

The core air is compressed by the LPC rotor 63 and the HPC rotor 64 and is directed into a combustion chamber 116 of a combustor 118 in the combustor section 42. Fuel is injected into the combustion chamber 116 by one or more fuel injectors 120 and mixed with the compressed core air to provide a fuel-air mixture. This fuel-air mixture is ignited and combustion products thereof flow through and sequentially drive rotation of the HPT rotor 65 and the LPT rotor 66. The rotation of the HPT rotor 65 and the LPT rotor 66 respectively drive rotation of the HPC rotor 64 and the LPC rotor 63 and, thus, compression of the air received from the core inlet 54. The rotation of the LPT rotor 66 also drives rotation of the propulsor rotor 62 through the RSP drivetrain 74. The rotation of the propulsor rotor 62 propels the bypass air through and out of the bypass flowpath 52 to provide forward aircraft thrust.

While the turbine engine 24 is described above with a particular two rotating structure arrangement (e.g., a two-spool architecture), the present disclosure is not limited thereto. For example, the LPC rotor 63 may be omitted to configure the LPT rotor 66 as a power turbine (PT) rotor for the propulsor rotor 62. The turbine engine 24 may also or alternatively include another rotating structure with a bladed compressor rotor in the compressor section 41 and a bladed turbine rotor in the turbine section 43; e.g., an intermediate speed spool for the engine core 48.

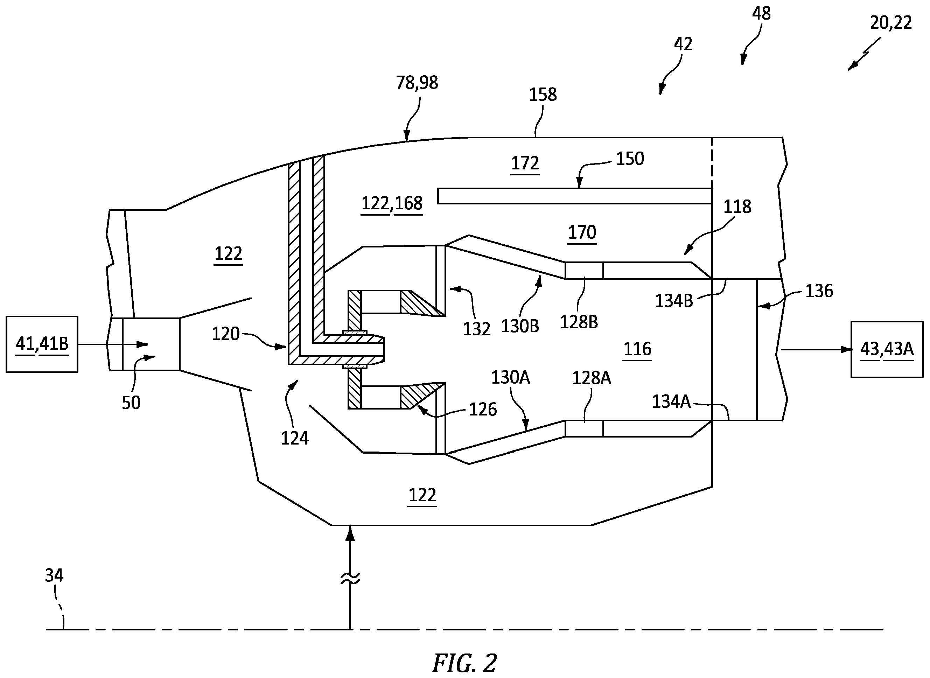

FIG. 2 illustrates a portion of the combustor section 42 along the core flowpath 50 between the HPC section 41B and the HPT section 43A (schematically shown). This combustor section 42 includes the combustor 118, a diffuser plenum 122 and the one or more injector assemblies 124 (one visible in FIG. 2). Briefly, the combustor 118 is disposed within (e.g., surrounded by) the diffuser plenum 122. This diffuser plenum 122 receives the compressed core air from the HPC section 41B for subsequent provision into the combustion chamber 116. Each injector assembly 124 of FIG. 2 includes a respective one of the fuel injectors 120 mated with an air swirler structure 126. The fuel injector 120 of FIG. 2 injects the fuel into the combustion chamber 116. The air swirler structure 126 directs some of the core air from the diffuser plenum 122 into the combustion chamber 116 in a manner that facilitates mixing the core air with the injected fuel. One or more igniters (not shown) ignite the fuel-air mixture within the combustion chamber 116. One or more quench apertures 128A, 128B (generally referred to as "128") (e.g., dilution holes) in each wall 130A, 130B (generally referred to as "130") of the combustor 118 may direct additional core air from the diffuser plenum 122 into the combustion chamber 116 to facilitate substantially complete burnout of (e.g., make stoichiometrically lean) the combustion products; e.g., the ignited fuel-air mixture.

The combustor 118 may be configured as an annular combustor; e.g., an annular floating wall combustor. The combustor 118 of FIG. 2, for example, includes an annular combustor bulkhead 132, the tubular inner combustor wall 130A and the tubular outer combustor wall 130B. The bulkhead 132 of FIG. 2 extends radially between and to the inner combustor wall 130A and the outer combustor wall 130B. The bulkhead 132 may be connected (e.g., mechanically fastened or otherwise attached) to the inner combustor wall 130A and/or the outer combustor wall 130B. Each combustor wall 130 projects axially along the propulsion system axis 34 out from the bulkhead 132 towards the HPT section 43A. The inner combustor wall 130A of FIG. 2, for example, projects axially to and may be connected to an (e.g., tubular) inner platform 134A of a downstream stator vane array 136 in the HPT section 43A. The outer combustor wall 130B of FIG. 2 projects axially to and may be connected to an (e.g., tubular) outer platform 134B of the downstream stator vane array 136. With the arrangement of FIG. 2, the combustion chamber 116 is formed by and extends radially within the combustor 118 between and to the inner combustor wall 130A and the outer combustor wall 130B. The combustion chamber 116 is formed by and extends axially (in an upstream direction along the core flowpath 50) into the combustor 118 from the stator vane array 136 to the bulkhead 132. The combustion chamber 116 also extends within the combustor 118 circumferentially about (e.g., completely around) the propulsion system axis 34, for example configuring the combustion chamber 116 of FIG. 2 as a full-hoop annulus.

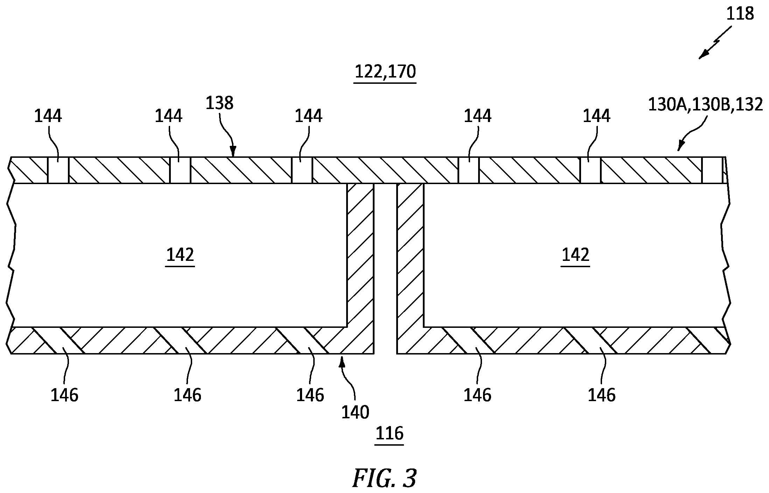

Referring to FIG. 3, any one or more or all of the combustor members 130A, 130B and/or 132 may each be configured as a multi-walled structure; e.g., a hollow, dual-walled structure. Each combustor members 130A, 130B, 132 of FIG. 3, for example, includes a shell 138, a heat shield 140 (e.g., a liner) and one or more combustor wall cooling cavities 142 (e.g., impingement cavities) which are formed by and are disposed (e.g., radially and/or axially) between the shell 138 and the heat shield 140. Each cooling cavity 142 of FIG. 3 is fluidly coupled with the diffuser plenum 122 through one or more cooling apertures 144 in the shell 138; e.g., impingement apertures. Each cooling cavity 142 of FIG. 3 is fluidly coupled with the combustion chamber 116 through one or more cooling apertures 146 in the heat shield 140; e.g., effusion apertures. Of course, various other multi-walled combustor structures are known in the art, and the present disclosure is not limited to any particular ones thereof. Furthermore, it is contemplated any one or more or all of the combustor members 130A, 130B and/or 132 of FIG. 2 may each alternatively be configured as a single-walled structure. The shell 138 of FIG. 3, for example, may be omitted and the heat shield 140 may form a single walled liner / wall.

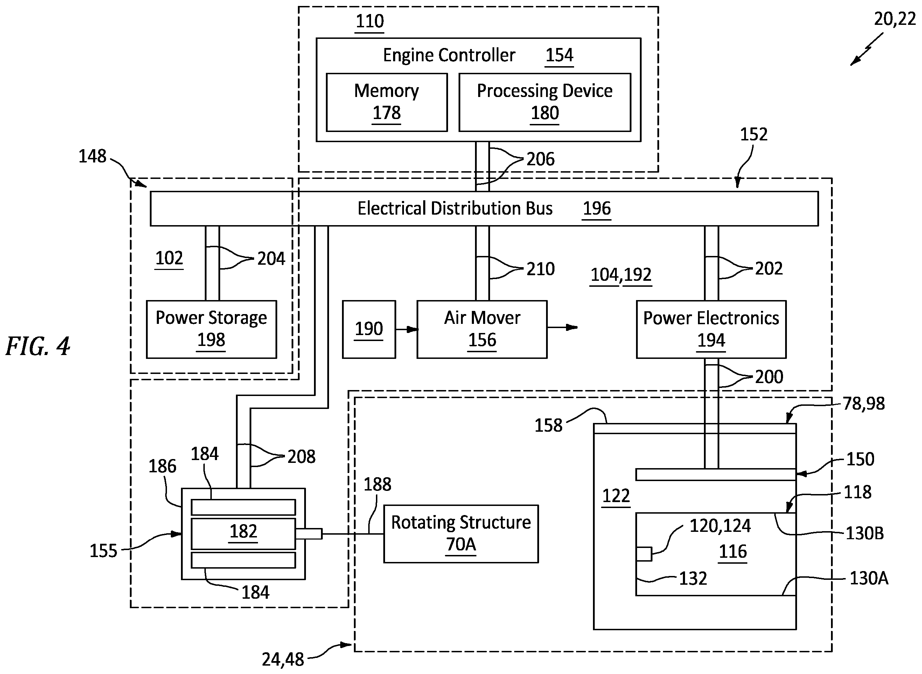

FIG. 4 is a partial schematic illustration of an electrical system 148 for the aircraft propulsion system 22 and its turbine engine 24 (see also FIG. 1). This electrical system 148 may be configured to facilitate (e.g., control) one or more operations for the aircraft propulsion system 22 during operation of the turbine engine 24. The electrical system 148 may also or alternatively be configured to facilitate (e.g., control and perform) at least one operation for the aircraft propulsion system 22 while the turbine engine 24 is non-operational (e.g., turned off, depowered, etc.). For example, the electrical system 148 may facilitate a post-engine shutdown procedure for the aircraft propulsion system 22 (e.g., immediately) following turbine engine shutdown.

The electrical system 148 of FIG. 4 includes a thermoelectric generator 150, one or more electric devices and an electrical power system 152. For ease of description, a first of the electric devices is described below as an electronic engine controller (EEC) 154. A second of the electric devices is described below as an electric motor such as a core turning motor 155, which may be configured as a motor-generator. A third of the electric devices is described below as an electric air mover 156. The present disclosure, however, is not limited to such exemplary electric devices. For example, any one or more of the electric devices 154-156 may be omitted from the electrical system 148. The electrical system 148, for example, may alternatively be dedicated to (e.g., only include) a single one or two of the electric devices 154-156. In another example, the electrical system 148 may also or alternatively include one or more other electric devices. Examples of these other electric devices include, but are not limited to, one or more engine sensors, one or more electric machines (e.g., other electric motor(s), electric motor-generator(s)), one or more valves, one or more electric actuators, and/or the like.

The thermoelectric generator 150 may be configured as or otherwise include a thermoelectric generator panel or an array of thermoelectric generator panels. This thermoelectric generator 150 and each thermoelectric generator panel is configured to convert heat energy generated during operation of the turbine engine 24 into electricity. This conversion of the heat energy to electricity may occur during operation of the turbine engine 24. The conversion of the heat energy to electricity may also or alternatively occur post-engine shutdown as one or more internal components of the turbine engine 24 and/or gases (e.g., combustion products) within the turbine engine 24 cool down from previously elevated engine operating temperatures. More particularly, the thermoelectric generator 150 of FIG. 4 is configured to convert heat energy radiated from the combustor 118 (and more broadly from the combustor section 42) into electricity. The thermoelectric generator 150, for example, may be configured as or otherwise include a solid-state generator such as a Seebeck generator.

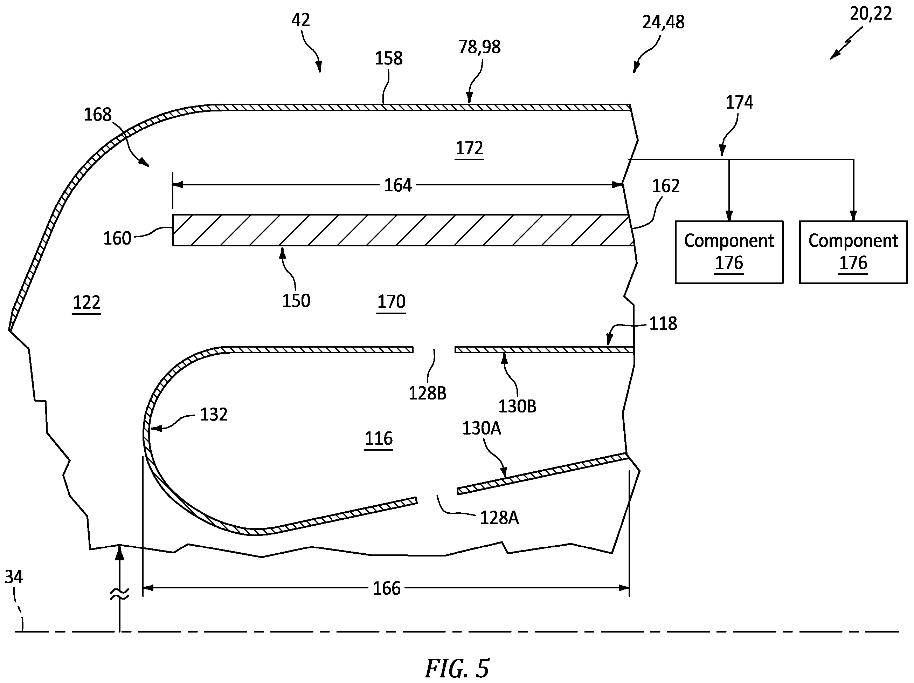

Referring to FIG. 5, the thermoelectric generator 150 is arranged with the combustor 118 within the combustor section 42. The thermoelectric generator 150 of FIG. 5, for example, is arranged in the diffuser plenum 122 between the combustor 118 and a diffuser casing 158. Briefly, the diffuser casing 158 may be a tubular section of the inner case 78 that axially overlaps and circumscribes the diffuser plenum 122 and the combustor 118. The inner case 78 and its diffuser casing 158 of FIG. 5, for example, form a radial outer peripheral boundary of the diffuser plenum 122 at a radial inner side of the diffuser casing 158. The thermoelectric generator 150 of FIG. 5 is disposed radially between the outer combustor wall 130B and the diffuser casing 158. The thermoelectric generator 150 of FIG. 5 is also (a) spaced radially outward (away from the propulsion system axis 34) from the combustor 118 and its outer combustor wall 130B and (b) spaced radially inward (towards the propulsion system axis 34) from the inner case 78 and its diffuser casing 158.

The thermoelectric generator 150 extends axially along the propulsion system axis 34 between opposing axial ends 160 and 162 of the thermoelectric generator 150. The thermoelectric generator 150 has an axial end-to-end length 164 measured along the propulsion system axis 34 between the opposing generator ends 160 and 162. This generator length 164 may be equal to or greater than fifty percent (50%), seventy percent (70%) or ninety percent (90%) of an axial end-to-end length 166 of the combustor 118. The thermoelectric generator 150 also axially overlaps the combustor 118 and its outer combustor wall 130B. The thermoelectric generator 150 of FIG. 5, more particularly, axially overlaps at least fifty percent (50%), seventy percent (70%) or ninety percent (90%) of the combustor 118 along its combustor length 166. The thermoelectric generator 150 also extends circumferentially about (e.g., partially or completely around) the propulsion system axis 34 within the diffuser plenum 122. The thermoelectric generator 150 may thereby extend partially circumferentially about or circumscribe the combustor 118 and its outer combustor wall 130B.

A radial outer region 168 (e.g., annulus) of the diffuser plenum 122 is formed by and extends radially between (a) the combustor 118 and its outer combustor wall 130B and (b) the inner case 78 and its diffuser casing 158. The thermoelectric generator 150 may separate (e.g., divide) the outer region 168 of the diffuser plenum 122 into an inner flow channel 170 and an outer flow channel 172. The thermoelectric generator 150 may thereby operate as a flow divider / a flow guide within the diffuser plenum 122. The thermoelectric generator 150 may also operate as a heat shield between the combustor 118 and the outer diffuser casing 158.

The inner flow channel 170 is disposed radially between and borders (a) the combustor 118 and its outer combustor wall 130B and (b) the thermoelectric generator 150. More particularly, a radial inner peripheral boundary of the inner flow channel 170 (as well as the outer region 168 of the diffuser plenum 122) is formed by and extends axially and circumferentially along a radial outer side of the outer combustor wall 130B. A radial outer peripheral boundary of the inner flow channel 170 is formed by and extends axially and circumferentially along a radial inner side of the thermoelectric generator 150. This inner flow channel 170 is fluidly coupled to and is configured to supply a flow of the pressurized core air within the diffuser plenum 122 to the outer quench apertures 128B (see also FIG. 2) and/or the shell cooling apertures 144 (see FIG. 3).

The outer flow channel 172 is disposed radially between and borders (a) the thermoelectric generator 150 and (b) the inner case 78 and its diffuser casing 158. More particularly, a radial inner peripheral boundary of the outer flow channel 172 is formed by and extends axially and circumferentially along a radial outer side of the thermoelectric generator 150. A radial outer peripheral boundary of the outer flow channel 172 (as well as the outer region 168 of the diffuser plenum 122) is formed by and extends axially and circumferentially along a radial inner side of the diffuser casing 158. This outer flow channel 172 is fluidly coupled to and is configured to supply another flow of the pressurized core air within the diffuser plenum 122 to an air circuit 174. This air circuit 174 may extend longitudinally between and fluidly couples the outer flow channel 172 to one or more downstream engine components 176. The air circuit 174 may thereby deliver the flow of the pressurized core air to the downstream engine components 176 for cooling those downstream engine components 176. Examples of the downstream engine components 176 include, but are not limited to, one or more turbine vane structures (e.g., the stator vane array 136 of FIG. 2), one or more outer rotor shrouds (e.g., blade outer air seals (BOAS)), and/or the like.

Referring to FIG. 4, the engine controller 154 is configured to control operation of the turbine engine 24. The engine controller 154, for example, may receive one or more commands from an aircraft operator (e.g., a pilot, computing system configured to control operation of the aircraft) and/or sensor data from a sensor system for the aircraft propulsion system 22 and its turbine engine 24. The engine controller 154 may process the commands and/or the sensor data to generate one or more control signals. These control signals may be output from the engine controller 154 to one or more components of the aircraft propulsion system 22 (e.g., actuators, pumps, valves, etc.) to facilitate operation of those components. The engine controller 154, for example, may be configured as or otherwise include a full-authority digital engine controller (FADEC).

The engine controller 154 may be implemented with a combination of hardware and software. The hardware may include memory 178 and at least one processing device 180, which processing device 180 may include one or more single-core and/or multi-core processors. The memory 178 is configured to store software (e.g., program instructions) for execution by the processing device 180, which software execution may control and/or facilitate various turbine engine operations. The hardware may also or alternatively include analog and/or digital circuitry other than that described above.

The core turning motor 155 includes an electric motor rotor 182, an electric motor stator 184 and an electric motor housing 186; e.g., a case. The motor stator 184 of FIG. 4 is radially outboard of and circumscribes the motor rotor 182. With this arrangement, the core turning motor 155 is configured as a radial flux electric motor. The core turning motor 155 of the present disclosure, however, is not limited to such an exemplary rotor-stator configuration nor to radial flux arrangements. The motor rotor 182, for example, may alternatively be radially outboard of and circumscribe the motor stator 184. In another example, the motor rotor 182 may be axially next to the motor stator 184 configuring the core turning motor 155 as an axial flux electric motor. Referring again to FIG. 4, the motor rotor 182 and the motor stator 184 are at least partially or completely housed within an interior of the motor housing 186.

The core turning motor 155 is operatively coupled to the turbine engine 24 and its engine core 48. More particularly, the core turning motor 155 is operatively coupled to the high speed rotating structure 70A. The motor rotor 182 of FIG. 4, for example, is mechanically coupled to the high speed rotating structure 70A through a core-to-electric motor (CEM) drivetrain 188. This CEM drivetrain 188 may be configured as or otherwise include a shaft, a tower shaft assembly, an accessory gearbox, another gearbox (e.g., an angle gearbox), and/or the like. With this arrangement, when energized, the core turning motor 155 may drive rotation of the high speed rotating structure 70A.

The air mover 156 may be configured as or otherwise include an electric blower, an electric pump and/or an electric compressor. This air mover 156 is fluidly coupled between an air source 190 and an air sink 192. Examples of the air source 190 include, but are not limited to, the bypass flowpath 52 of FIG. 1 or the external environment 112 of FIG. 1. Examples of the air sink 192 include the aft inner housing compartment 104 and/or another volume internal to the aircraft propulsion system 22. With this arrangement, when energized, the air mover 156 may direct air received from the air source 190 into the air sink 192. This air may be directed into the air sink 192 to ventilate the air sink 192; e.g., ventilate the aft inner housing compartment 104. The air may also or alternatively be directed into the air sink 192 to convectively cool one or more components within and/or bordering the air sink 192.

The electrical power system 152 is configured to electrically couple the thermoelectric generator 150 to the one or more electric devices 154-156. The electrical power system 152 of FIG. 4, for example, includes power electronics 194 and an electrical distribution bus 196. The electrical power system 152 may also include a power storage 198.

The power electronics 194 may be electrically coupled between the thermoelectric generator 150 and the electrical distribution bus 196. The power electronics 194, for example, may be electrically coupled to the thermoelectric generator 150 through one or more electric cables 200. Similarly, the power electronics 194 may be electrically coupled to the electrical distribution bus 196 through one or more electric cables 202. The power electronics 194 may be configured to condition the electrical power (electricity) generated by the thermoelectric generator 150 into electrical power which may be more readily used by the electric devices 154-156. The power electronics 194, for example, may include an electrical power converter, an electrical amplifier, an electrical inductor, an electrical transformer, an electrical rectifier, and/or the like.

The power storage 198 is configured to receive at least some of the electrical power generated by the thermoelectric generator 150 for storage. The power storage 198 is also configured to provide at least some of the stored electrical power one or more or all of the electric devices 154-156. The power storage 198, for example, may be configured as or otherwise include one or more electricity storage devices such as batteries, super capacitors, and/or the like.

The electrical distribution bus 196 is configured to electrically interconnect the various members of the electrical system 148. The thermoelectric generator 150, for example, may be electrically coupled to the electrical distribution bus 196 through the power electronics 194 as described above. The power storage 198 may be electrically coupled to the electrical distribution bus 196 through one or more electric cables 204. The engine controller 154 may be electrically coupled to the electrical distribution bus 196 through one or more electric cables 206. The core turning motor 155 may be electrically coupled to the electrical distribution bus 196 through one or more electric cables 208. The air mover 156 may be electrically coupled to the electrical distribution bus 196 through one or more electric cables 210.

The electrical system 148 of FIG. 4 may operate in various modes of operation. A first mode of operation may occur while the turbine engine 24 is (e.g., fully) operational; e.g., operating after engine startup. A second mode of operation may occur, by contrast, while the turbine engine 24 is non-operational; e.g., turned off, depowered, etc.

During the first operating mode, the thermoelectric generator 150 may convert thermal energy radiated out from the combustor 118 while combustion is occurring in the combustion chamber 116 into electrical power. The electrical power system 152 may direct at least some or all of this electrical power to the power storage 198 for later use. The electrical power system 152 may also or alternatively direct at least some or all of the electrical power to the engine controller 154 to facilitate operation of that engine controller 154. The electrical power system 152 may still also or alternatively direct at least some or all of the electrical power to the air mover 156 to facilitate operation of that air mover 156. Here, the air mover 156 may be operated to facilitate ventilation of the aft inner housing compartment 104 (the air sink 192) and/or cooling of the component(s) within and/or bordering the aft inner housing compartment 104 (the air sink 192).

During the second operating mode, the thermoelectric generator 150 may convert thermal energy radiated out from the combustor 118 while the turbine engine 24 is non-operational; e.g., after engine shutdown and subsequent flameout in the combustion chamber 116. To facilitate a post-engine shutdown procedure for the aircraft propulsion system 22 (e.g., immediately) following turbine engine shutdown, the electrical power system 152 may direct at least some or all of the electrical power to the air mover 156 to facilitate operation of that air mover 156. Here, the air mover 156 may be operated to facilitate ventilation of the aft inner housing compartment 104 (the air sink 192) and/or cooling of the component(s) within and/or bordering the aft inner housing compartment 104 (the air sink 192). The electrical power system 152 may also or alternatively direct at least some or all of the electrical power to the core turning motor 155 to facilitate operation of that core turning motor 155. Here, the core turning motor 155 may drive rotation of the high speed rotating structure 70A to reduce or prevent air stagnation within the engine core 48, particularly where that air is heated by the still cooling components of the engine core 48. The operation of the air mover 156 and the core turning motor 155 may be continued for a period of time following shutdown of the turbine engine 24. It should be noted, while the electric devices 155 and 156 are described above as receiving the electrical power from the thermoelectric generator 150, it is contemplated this electrical power may be boosted by electrical power from the power storage 198. In addition, a run time of the electric devices 155 and 156 may be extended by using the power storage 198.

In some embodiments, referring to FIG. 1, the engine controller 154 may be arranged in the outer housing compartment 110. The core turning motor 155, the air mover 156 and/or the power electronics 194 may be arranged in the aft inner housing compartment 104. The power storage 198 may be arranged in the forward inner housing compartment 102. The present disclosure, however, is not limited to such an exemplary arrangement.

While various embodiments of the present disclosure have been described, it will be apparent to those of ordinary skill in the art that many more embodiments and implementations are possible within the scope of the disclosure. For example, the present disclosure as described herein includes several aspects and embodiments that include particular features. Although these features may be described individually, it is within the scope of the present disclosure that some or all of these features may be combined with any one of the aspects and remain within the scope of the disclosure. Accordingly, the present disclosure is not to be restricted except in light of the attached claims and their equivalents.

## Claims

1. An assembly for an aircraft powerplant (20), comprising:
an engine case extending axially along and circumferentially around an axis (34), the engine case forming an outer peripheral boundary of a diffuser plenum (122);
a combustor (118) disposed in the diffuser plenum (122), the combustor (118) including a combustor wall (130) and a combustion chamber (116) within the combustor (118), the combustor wall (130) bordering the diffuser plenum (122) and forming an outer peripheral boundary of the combustion chamber (116); and
a thermoelectric generator (150) arranged in the diffuser plenum (122), the thermoelectric generator (150) located radially between and spaced radially from the combustor wall (130) and the engine case, and the thermoelectric generator (150) configured to convert heat energy radiated out from the combustor (118) into electricity.

2. The assembly of claim 1, wherein the thermoelectric generator (150) comprises a thermoelectric generator panel extending axially along and circumferentially about the combustor wall (130).

3. The assembly of claim 1 or 2, wherein:
the thermoelectric generator (150) is arranged in the diffuser plenum (122) to separate a region of the diffuser plenum (122) into an inner flow channel (170) and an outer flow channel (172);
the inner flow channel (170) is disposed radially between and formed by the combustor wall (130) and the thermoelectric generator (150); and
the outer flow channel (172) is disposed radially between and formed by the thermoelectric generator (150) and the engine case.

4. The assembly of claim 3, wherein the inner flow channel (170) is fluidly coupled to one or more apertures (128) in the combustor wall (130).

5. The assembly of claim 3 or 4, further comprising:
an engine component (176); and
an air circuit (174) fluidly coupled to the outer flow channel (172) and configured to deliver air received from the outer flow channel (172) to the engine component (176).

6. The assembly of any preceding claim, wherein the thermoelectric generator (150) axially overlaps at least fifty percent of an axial length of the combustor (118).

7. The assembly of any preceding claim, further comprising:
an electric device; and
an electrical power system (152) electrically coupled to and between the thermoelectric generator (150) and the electric device,
wherein, optionally:
the electric device comprises an electronic engine controller (154); and/or
the electric device comprises an electric air mover (156).

8. The assembly of claim 7, wherein the electric device comprises an electric motor (155).

9. The assembly of claim 8, further comprising:
a compressor section (41);
a combustor section (42) comprising the combustor (118);
a turbine section (43);
a flowpath extending through the compressor section (41), the combustor section (42) and the turbine section (43) from an airflow inlet (54) into the flowpath to a combustion products exhaust (56) from the flowpath; and
a rotating structure comprising a bladed rotor disposed in the compressor section (41) or the turbine section (43);
the electric motor (155) operatively coupled to and configured to drive rotation of the rotating structure.

10. The assembly of claim 7, 8 or 9, wherein:
the electrical power system (152) comprises a power storage (198); and/or
the electrical power system (152) comprises an electrical distribution bus (196); and/or
the electrical power system (152) comprises power electronics (194).

11. The assembly of claim 7, 8, 9 or 10, further comprising:
a turbine engine (24) comprising the engine case, the diffuser plenum (122) and the combustor (118);
the electrical power system (152) configured to electrically power the electric device at least when the turbine engine (24) is non-operational subsequent to the turbine engine (24) being shutdown.

12. The assembly of claim 11, wherein the electrical power system (152) is configured to electrically power the electric device by directing at least some of the electricity generated by the thermoelectric generator (150) to the electric device.

13. The assembly of claim 11 or 12, wherein:
the electrical power system (152) comprises a power storage (198);
the electrical power system (152) is configured to store at least some of the electricity generated by the thermoelectric generator (150) in the power storage (198); and
the electrical power system (152) is configured to electrically power the electric device by directing at least some of the electricity stored in the power storage (198) to the electric device.

14. An assembly for an aircraft powerplant (20), comprising:
a turbine engine (24) including a combustor (118) disposed in a diffuser plenum (122); and
an electrical system (148) including a thermoelectric generator (150), an electric device and an electrical power system (152);
the thermoelectric generator (150) arranged in the diffuser plenum (122), the thermoelectric generator (150) configured to convert heat energy radiated out from the combustor (118) into electricity;
the electrical power system (152) electrically coupled to and between the thermoelectric generator (150) and the electric device, the electrical power system (152) configured to electrically power the electric device for a period of time following shutdown of the turbine engine (24); and
the electric device configured to facilitate a cool down operation for the turbine engine (24),
wherein, optionally, the electric device is configured to one of:
ventilate an internal compartment of the turbine engine (24) to facilitate the cool down operation for the turbine engine (24); and/or
rotate a rotating structure of the turbine engine (24) to facilitate the cool down operation for the turbine engine (24), the rotating structure comprising a bladed rotor in a compressor section (41) of the turbine engine (24) or a turbine section (43) of the turbine engine (24).

15. An assembly for an aircraft powerplant (20), comprising:
a combustor (118) including an inner combustor wall (130A), an outer combustor wall (130B), a bulkhead (132) and a combustion chamber (116), the inner combustor wall (130A) extending axially along and circumferentially about an axis (34), the outer combustor wall (130B) extending axially along and circumferentially about the inner combustor wall (130A), the bulkhead (132) extending radially between the inner combustor wall (130A) and the outer combustor wall (130B), the combustion chamber (116) projecting axially into the combustor (118) to the bulkhead (132), and the combustion chamber (116) extending radially between the inner combustor wall (130A) and the outer combustor wall (130B); and
a thermoelectric generator (150) radially outboard of and axially overlapping the combustor (118), an air channel (170) formed by and extending radially between the outer combustor wall (130B) and the thermoelectric generator (150).
